# EUROPÄISCHE PATENTSCHRIFT

(11) **EP 0 789 251 B1**
(45) Veröffentlichungstag und Bekanntmachung des Hinweises auf die Patenterteilung: **26.09.2001**
(21) Anmeldenummer: 97200207.5
(22) Anmeldetag: 27.01.1997
(51) Int. Cl.: G01R 33/561, G01R 33/565, G01R 33/3875

(54) **MR-Verfahren zur Bestimmung der Magnetfeldinhomogenität im Untersuchungsbereich und MR-Gerät zur Durchführung des Verfahrens**
MR method for determining magnetic field inhomogeneity over the examining region and MR apparatus for carrying out the method
Procédé RM de détermination de l'inhomogénéité du champ magnétique dans la région d'examen et dispositif RM pour la mise en oeuvre du procédé

(30) Priorität: 08.02.1996 DE 19604519
(43) Veröffentlichungstag der Anmeldung: 13.08.1997
(73) Patentinhaber: Philips Corporate Intellectual Property GmbH, 52064 Aachen (DE); Koninklijke Philips Electronics N.V., 5621 BA Eindhoven (NL)
(72) Erfinder: Rasche, Volker, Dr., Röntgenstrasse 24, 22335 Hamburg (DE)
(74) Vertreter: Hartmann, Heinrich, Dipl.-Ing.

(56) Entgegenhaltungen:
- EP-A- 0 240 319
- DE-A- 3 422 688
- US-A- 4 761 614
- US-A- 4 896 113
- US-A- 5 307 808
- US-A- 5 371 465
- MAGNETIC RESONANCE IN MEDICINE, Bd. 34, Nr. 5, November 1995, Seiten 754-761, XP000652854 RASCHE V ET AL: "CONTINUOUS RADIAL DATA ACQUISITION FOR DYNAMIC MRI"
- MAGNETIC RESONANCE IN MEDICINE, Bd. 32, Nr. 5, 1.November 1994, Seiten 629-638, XP000479920 RASCHE V ET AL: "RADIAL TURBO SPIN ECHO IMAGING"
- P.JEZZARD ET AL.: "Correction for Geometric Distortion in Echo Planar Images from Bo Field Variations", MAGN.RES.MED., , 1995, Band 34, Nr. , Seiten 65 - 73

## Beschreibung

Die Erfindung betrifft ein MR-Verfahren, bei dem aus wenigstens zwei mit unterschiedlichen Echozeiten akquirierten MR-Bildern eines einem stationären Magnetfeld ausgesetzten Untersuchungsbereiches eine die Magnetfeldinhomogenität im Untersuchungsbereich repräsentierende Frequenzverteilung abgeleitet wird. Ein solches Verfahren ist aus der EP-A-465 139 bekannt.

Bei MR-Untersuchungen (MR-Magnetresonanz) ist es für die Bildqualität wesentlich, daß das stationäre Magnetfeld im Untersuchungsbereich möglichst homogen ist. Zu diesem Zweck enthalten MR-Geräte sogenannte Shim-Spulen zur lokalen Änderung des stationären Magnetfeldes, das von einem Hauptfeldmagneten erzeugt wird. Bei geeigneter Einstellung der Ströme in den Shim-Spulen läßt sich die Inhomogenität des von dem Hauptfeldmagneten im Untersuchungsbereich erzeugten stationären Magnetfeldes verringern. Wie aus der EP-A-465 139 bekannt, kann man Shim-Felder erster Ordnung auch mittels von in einem MR-Gerät für die Bildgebung ohnehin erforderlichen Gradientenspulen erzeugen, während Shim-Felder höherer Ordnung nur von den eigentlichen Shim-Spulen zu erzeugen sind.

Bei der bekannten Anordnung erfolgt die Einstellung der Ströme durch die Shim-Spulen in Abhängigkeit von einer zuvor gemessenen Frequenzverteilung (frequency map oder homogeneity map), die die Magnetfeldinhomogenität im Untersuchungsbereich darstellt. Die Inhomogenität des Magnetfeldes wird auch von lokalen Änderungen der magnetischen Suszeptibilität innerhalb des im Untersuchungsbereich zu untersuchenden Objektes bestimmt. Die Frequenzverteilung muß daher jedesmal dann von neuem bestimmt werden, wenn ein anderer Patient untersucht wird, aber auch dann, wenn von denselben Patienten unterschiedliche Bereiche untersucht werden.

Bei dem bekannten Verfahren wird die Frequenzverteilung aus zwei MR-Bildern abgeleitet, die aus MR-Signalen rekonstruiert werden, die mit unterschiedlichen Echozeiten - im übrigen aber auf identische Weise - akquiriert wurden. Auch wenn diese MR-Bilder ein geringes räumliches Auflösungsvermögen haben als die bei der eigentlichen MR-Untersuchung aufgenommenen MR-Bilder, steht bei verschiedenen MR-Untersuchungen die Zeit zur Akquisition dieser beiden MR-Bilder nicht zur Verfügung. Bei interventionellen MR-Untersuchungen beispielsweise ändert sich fortlaufend die Lage des Untersuchungsbereichs, so daß die Frequenzverteilung fortlaufend aktualisiert werden müßte, was bisher nicht möglich war, weil dazu jeweils zwei MR-Bilder hätten akquiriert werden müssen.

Verfahren zur Bestimmung der Inhomogenität eines Magnetfeldes, bei denen nach einer Anregung zwei Echosignale längs desselben k-Raum-Pfades aufgenommen werden, sind z.B. aus DE-A-3422688, Magn. Res. Med. 34 (1995) S,65-73 und US-A-5 371 465 bekannt.

Es ist Aufgabe der vorliegenden Erfindung, ein MR-Verfahren der eingangs genannten Art so auszugestalten, daß eine besonders schnelle Akquisition der beiden MR-Bilder möglich wird. Diese Aufgabe wird erfindungsgemäß durch die im Anspruch 1 angegebenen Maßnahmen gelöst.

Bei der Erfindung werden nach jeder Anregung der Kernmagnetisierung wenigstens zwei MR-Echosignale längs unterschiedlichen Pfaden im k-Raum akquiriert, die den Nullpunkt des k-Raums in unterschiedlichen Richtungen passieren. Deshalb haben diese MR-Echosignale auch unterschiedliche Echozeiten. Aus den MR-Echosignalen, die in unterschiedlichen Sequenzen jeweils mit der gleichen Echozeit akquiriert wurden, wird ein MR-Bild abgeleitet, so daß mehrere MR-Bilder mit unterschiedlichen Echozeiten entstehen. Aus zwei MR-Bildern kann dann in bekannter Weise die Frequenzverteilung abgeleitet werden. Die Verkürzung der für die Akquisition der MR-Echosignale benötigten Zeit ergibt sich dabei allein schon daraus, daß nach jeder Anregung wenigstens zwei MR-Echosignale erfaßt werden.

Eine weitere Verkürzung ergibt sich dann, wenn nach einer bevorzugten Ausgestaltung der Erfindung das MR-Verfahren so ausgeführt wird, daß die aus den einzelnen Gruppen abgeleiteten MR-Bilder zu einem MR-Gesamtbild überlagert werden. Die eigentliche MR-Untersuchung wird also mit Hilfe des auf diese Weise gewonnenen MR-Gesamtbildes durchgeführt, so daß die Akquisition der MR-Bilder, aus denen die Frequenzverteilung abgeleitet wird, keine zusätzliche Untersuchungszeit erfordert. Dies ist insbesondere dann von Bedeutung, wenn die Frequenzverteilung fortlaufend aktualisiert werden soll. - Voraussetzung dabei ist, daß die innerhalb einer Sequenz akquirierten MR-Echosignale den Nullpunkt des k-Raums jeweils in unterschiedlichen Richtungen passieren. Die aus den MR-Echosignalen einzelner Gruppen rekonstruierten MR-Bilder haben ein geringeres räumliches Auflösungsvermögen als das für die eigentliche MR-Untersuchung vorgesehene MR-Gesamtbild. Dies reicht jedoch aus, weil sich das stationäre Magnetfeld örtlich nur relativ langsam ändert.

In weiterer Ausgestaltung der Erfindung ist vorgesehen, daß zur lokalen Änderung des stationären Magnetfeldes Shim-Spulen und/oder eine Gradientenspulenanordnung vorgesehen sind und daß die Ströme durch die Shim-Spulen und/oder die Gradientenspulenanordnung in Abhängigkeit von der ermittelten Frequenzverteilung gesteuert werden. Wie eingangs erwähnt, können auch die Gradientenspulen magnetische Shim-Felder (erster Ordnung) erzeugen. Wenn bei einer MR-Untersuchung die Lage des Untersuchungsbereichs fortlaufend verändert wird, ergeben sich in noch weiterer Ausgestaltung der Erfindung besondere Vorteile dadurch, daß die Sequenzen fortlaufend auf den Untersuchungsbereich einwirken und daß die Ströme durch die Shim-Spulen und/oder die Gradientenspulenanordnung fortlaufend in Abhängigkeit von der ermittelten Frequenzverteilung gesteuert wird. Dies ist insbesondere für interventionelle MR-Untersuchungen wichtig.

Ein MR-Verfahren bei dem in wenigstens einer Sequenz die Kernmagnetisierung im Untersuchungsbereich durch wenigstens je einen Hochfrequenzimpuls angeregt wird und nach jeder Anregung der Kernmagnetisierung mehrere MR-Echosignale längs Pfaden im k-Raum akquiriert werden, die den Nullpunkt des k-Raums in unterschiedlichen Richtungen passieren, ist an sich aus einem Aufsatz von Norton in IEEE Trans. Med. Imaging, Vol. MI-6, pp. 21-31 bekannt. Dabei werden die MR-Echosignale längs eines Pfades im k-Raum akquiriert, der um den Nullpunkt des k-Raums oszilliert und dabei gleichzeitig langsam seine Richtung ändert. Die Pfade im k-Raum beschreiben dabei ein Muster, das um den um den Stiel einer Blume gruppierten Blütenblättern ähnelt, weshalb dieses Verfahren in der Fachwelt auch als "flower scan" bezeichnet wird. Der Vorteil dieses Verfahrens gegenüber dem Projektions-Rekonstruktionsverfahren, wie es aus der EP-A 73 671 bekannt ist, besteht darin, daß - zumindest theoretisch - die für die Rekonstruktion eines MR-Bildes erforderlichen MR-Echosignale mit einer einzigen Anregung der Kernmagnetisierung im Untersuchungsbereich erzeugt werden können. Der Nachteil gegenüber dem Verfahren nach der EP-B 73 671 besteht darin, daß die Pfade im k-Raum nicht geradlinig sind, so daß die Rekonstruktion der MR-Bilder aus den MR-Echosignalen relativ kompliziert ist.

Ein Verfahren der genannten Art, das die Vorteile der beiden bekannten Verfahren (gradlinige Abtastpfade und jeweils mehrere Echosignale nach einer Anregung der Kernmagnetisierung) in sich vereinigt, ist in Anspruch 5 angegeben. Dieses Verfahren läßt sich vorteilhaft dazu benutzen, die MR-Bilder für die Frequenzverteilung zu gewinnen.

Eine MR-Anordnung zur Durchführung des MR-Verfahrens zur Erzeugung der Frequenzverteilung ist in Anspruch 6 angegeben. Mit einer solchen MR-Anordnung lassen sich die nach der Erfindung bevorzugten MR-Sequenzen gemäß Anspruch 7 erzeugen.

Die Erfindung wird nachstehend anhand der Zeichnungen näher erläutert. Es zeigen
- Fig. 1: das Blockschaltbild des MR-Gerätes, mit dem die Erfindung ausführbar ist.
- Fig. 2: den zeitlichen Verlauf verschiedener Signale bei einer erfindungsgemäßen MR-Sequenz und
- Fig. 3: die Lage der Pfade im k-Raum, längs denen bei dieser Sequenz die MR-Echosignale akquiriert werden.

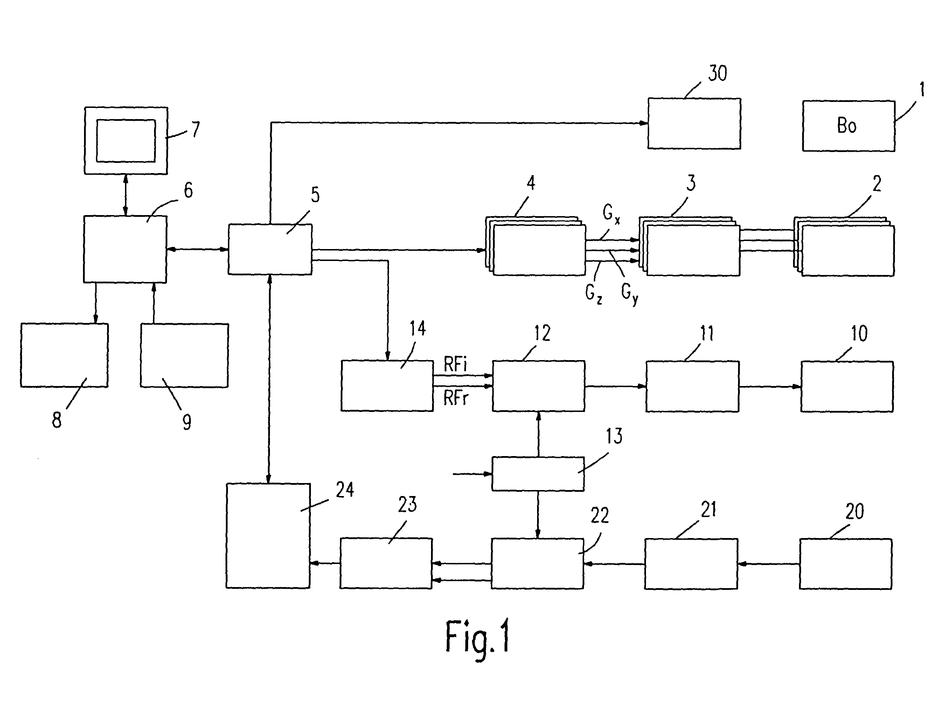

In Fig. 1 ist mit 1 ein schematisch dargestellter Hauptfeldmagnet bezeichnet, der in einem nicht näher dargestellten Untersuchungsbereich ein in z-Richtung verlaufendes stationäres und im wesentlichen homogenes Magnetfeld mit einer Stärke von z.B. 1,5 Tesla erzeugt. Außerdem ist eine Shim-Spulenanordnung 30 vorgesehen, die es gestattet, in Abhängigkeit von den durch die Shim-Spulen fließenden Strömen das Magnetfeld im Untersuchungsbereich zu verändern, und zwar so, daß das resultierende Magnetfeld insgesamt homogener wird. Die Shim-Spulenanordnung 30, mit der man Shim-Felder höherer Ordnung erzeugen kann, wird von einer Steuereinheit 5 gesteuert.

Weiterhin ist eine Gradientenspulenanordnung 2 vorgesehen, die in dem Untersuchungsbereich in z-Richtung verlaufende magnetische Gradientenfelder Gₓ, G_{y} und G_{z} mit einem Gradienten in x, y oder z-Richtung erzeugen kann. Die Gradientenspulenanordnung 2 wird von einer Gradientenverstärkeranordnung 3 gespeist. Der zeitliche Verlauf der magnetischen Gradientenfelder wird von einer Generatoranordnung 4 vorgegeben, die von der Steuereinheit 5 gesteuert wird. Die Steuereinheit 5 wirkt mit einer workstation 6 zusammen. Die workstation ist mit einem Monitor 7 zur Wiedergabe von MR-Bildern versehen. Eingaben sind über eine Tastatur 8 oder eine interaktive Eingabeeinheit 9, z.B. einen Lichtgriffel, möglich.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. Im Hochfrequenzsender werden die Einhüllenden eines Hochfrequenzimpulses mit den von einem Oszillator 13 gelieferten Trägerschwingungen moduliert, dessen Frequenz der Larmorfrequenz (bei einem Hauptfeld von 1,5 Tesla ca. 63 MHz) entspricht. Die Einhüllende wird von der Steuereinheit 5 in einen Generator 14 geladen, der mit dem Sender 12 gekoppelt ist.

Die im Untersuchungsbereich erzeugten MR-Signale werden von einer Empfangsspule 20 aufgenommen und von einem Verstärker 21 verstärkt. Das verstärkte MR-Signal wird in einem Quadraturdemodulator 22 durch zwei um 90° gegeneinander versetzte Trägerschwingungen des Oszillators 13 demoduliert, so daß im Niederfrequenzbereich zwei Signale erzeugt werden, die als Realteil und als Imaginärteil eines komplexen MR-Echosignals aufgefaßt werden können. Diese Signale werden einem Analog-Digital-Wandler 23 zugeführt, der daraus MR-Daten bildet. Diese werden einer Rekonstruktionseinheit 24 zugeführt, die im Zusammenwirken mit der Workstation aus den MR-Daten MR-Bilder rekonstruiert, die die Kernmagnetisierung im Untersuchungsbereich darstellen. Jedes MR-Bild ist durch komplexe Zahlen in seinen einzelnen Bildpunkten definiert, die den Betrag und die Phasenlage oder den Realteil und den Imaginärteil der komplexen Kernmagnetisierung in dem betreffenden Bildpunkt darstellen.

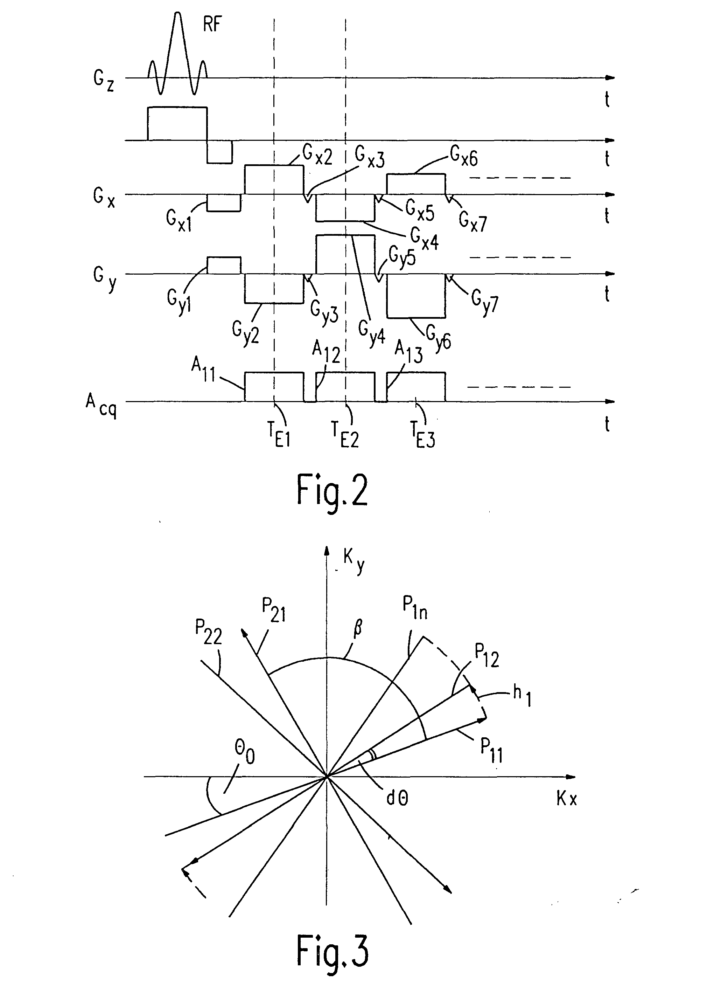

Gemäß Fig. 2 umfaßt jede Sequenz einen Hochfrequenzimpuls RF (1. Zeile von Fig. 2), der die Kernmagnetisierung in einer Schicht des Untersuchungsbereiches anregt, deren Dicke von der Stärke des gleichzeitig wirksamen Schichtselektionsgradienten G_{z} (2. Zeile von Fig. 2) abhängt sowie von der Bandbreite des Hochfrequenzimpulses RF. Nach dem Hochfrequenzimpuls RF wird ein magnetisches Gradientenfeld Gₓ₁ und G_{y1} (3. und 4. Zeile von Fig. 2) mit in x-bzw. y-Richtung wirkendem Gradienten ein- und ausgeschaltet, wodurch die Kernmagnetisierung auf einen maximalen Wert im k-Raum dephasiert wird, der den Anfangspunkt eines Pfades P₁₁ im k-Raum bildet. Die k-Werte kₓ bzw. k_{y} entsprechen bekanntlich dem zeitlichen Integral über Gₓ bzw. G_{y}.

Anschließend werden die Lesegradienten Gₓ₂ und G_{y2} geschaltet, deren zeitliches Integral doppelt so groß ist wie das von Gₓ₁ und G_{y1} und die die entgegengesetzte Polarität haben wie Gₓ₁ und G_{y1}. Solange die Gradienten Gₓ₂ und G_{y2} wirksam sind, wird ein MR-Echosignal akquiriert, wie in der 5. Zeile von Fig. 2 durch A₁₁ angedeutet. Das MR-Echosignal wird dabei längs des Pfades P₁₁ erfaßt, der von dem Anfangspunkt ausgehend den Nullpunkt des k-Raums unter einem Winkel *θ* ₀ passiert und dabei einen Endpunkt erreicht, der vom Nullpunkt des k-Raums genauso weit entfernt ist wie der Anfangspunkt.

Insoweit als bisher beschrieben, entspricht dieses MR-Verfahren der sogenannten Projektions-Rekonstruktionsmethode, die aus der EP-A 73-671 bekannt ist. Während jedoch bei dem bekannten Verfahren im Anschluß an die Erfassung eines MR-Echosignals längs des Pfades P₁₁ die Kernmagnetisierung in der Schicht erneut durch einen Hochfrequenzimpuls angeregt und das dadurch erzeugte MR-Echosignal längs eines Pfades ausgelesen wird, der den k-Raum unter einem anderen Winkel durchsetzt als beim Erfassen des ersten MR-Echosignals, wird bei dem erfindungsgemäßen Verfahren mindestens noch ein weiteres MR-Echosignal akquiriert, vorzugsweise aber mehrere Echosignale, die den Nullpunkt des k-Raums jeweils in unterschiedlichen Richtungen passieren.

Zu diesem Zweck wird im Anschluß an den Gradienten Gₓ₂ bzw. G_{y2} kurzzeitig ein Gradient Gₓ₃ bzw. G_{y3} ein- und ausgeschaltet - ein sogenannter "blip" -, dessen zeitliches Integral klein ist im Vergleich zum zeitlichen Signal über Gₓ₂ bzw. G_{y2}. Dadurch ergibt sich im k-Raum (Fig. 3) eine Verschiebung vom Endpunkt des Pfades P₁₁ zum Startpunkt des Pfades P₁₂ - entsprechend dem Pfeil h₁ in Fig. 3.

Anschließend wird ein Lesegradient mit den Komponenten Gₓ₄ und G_{y4} geschaltet, der dem Betrage nach dem Lesegradienten Gₓ₂, G_{y2} entspricht, aber die entgegengesetzte Polarität hat wie dieser. Die Richtung des diesem Gradienten zugeordneten Pfades P₁₂ im k-Raum ist so bemessen, daß sie den Nullpunkt passiert und dabei den Pfad P₁₁ unter einem Winkel d*θ* schneidet. Das während des Lesegradienten Gₓ₄, G_{y4} auftretende MR-Echosignal wird im Zeitraum A₁₂ erfaßt (5. Zeile von Fig. 2). dθ ist dabei das für eine bestimmte räumliche Auflösung erforderliche Winkel inkrement.

Anschließend werden wiederum blips Gₓ₅, G_{y5} geschaltet, wonach das MR-Signal im Zeitintervall A₁₃ längs eines in Fig. 3 nicht dargestellten Pfades mit den Lesegradienten Gₓ₆, G_{y6}, ausgelesen wird, der unter einem Winkel dθ zu dem Pfad P₁₂ verläuft. Auf diese Weise werden n MR-Echosignale im Anschluß an eine Anregung der Kernmagnetisierung durch den Hochfrequenzimpuls RF ausgelesen, wobei das letzte MR-Echosignal entlang des Pfades P₁ₙ erfaßt wird (Fig. 3). n muß kleiner sein als 360°/dθ und kann einen Wert haben zwischen 4 und 16.

Danach wird die Kernmagnetisierung in der zuvor angeregten Schicht durch einen Hochfrequenzimpuls erneut angeregt, wonach erneut n MR-Echosignale erfaßt werden. Der zeitliche Verlauf der Gradientenfelder Gₓ und G_{y} in dieser Sequenz ist jedoch so gewählt, daß die MR-Echosignale dabei längs Pfaden P₂₁, P₂₂ usw. verlaufen, die mit den Pfaden P₁₁, P₁₂ einen Winkel *β* einschließen, wie in Fig. 3 dargestellt. Danach folgen weitere Sequenzen, bei denen MR-Echosignale längs weiterer Pfade durch den k-Raum erfaßt werden, bis der k-Raum auf gleichmäßig (um das Winkelinkrement dθ) gegeneinander versetzten Strahlenpfaden abgetastet ist.

Bei dem in Fig. 3 in Verbindung mit Fig. 2 erläuterten Ausführungsbeispiel wurde davon ausgegangen, daß die Pfade im k-Raum, längs derer die MR-Echosignale erfaßt werden, symmetrisch zum Nullpunkt des k-Raums verlaufen, wobei der Anfang eines jeden Pfades genauso weit vom Nullpunkt entfernt ist wie das Ende dieses Pfades. Es ist aber auch möglich, die Pfade im Nullpunkt entweder beginnen oder enden zu lassen. Beginnt ein Pfad z.B. im Nullpunkt des k-Raums, dann endet er im Abstand davon, wie z.B. P₁₁ in Fig. 3. Nach einer Verschiebung um h₁ (Fig. 3) erfolgt der Empfang des nächsten MR-Echosignals entlang eines Pfades, der - wie z.B. P₁₂ - außerhalb beginnt, aber im Nullpunkt des k-Raums endet. Das darauf folgende MR-Echosignal wird wieder längs eines Pfades erfaßt, der wiederum vom Nullpunkt ausgeht - aber unter einem anderen Winkel.

Der Verlauf der magnetischen Gradientenfelder Gₓ, G_{y} muß dann wie folgt modifiziert werden: Cₓ₁ und G_{y1} entfallen. Das zeitliche Integral über die Lesegradienten Gₓ₂ ... Gₓ₆ bzw. G_{y2} ... G_{y6} ist nur noch halb so groß wie in Fig. 2. Jeder zweite blip (z.B. Gₓ₅ und G_{y5}) kann entfallen, weil der eine Pfad im gleichen Punkt beginnt (nämlich im Nullpunkt), in dem der vorherige Pfad geendet hat.

Bei der Verarbeitung der MR-Echosignale werden die MR-Echosignale zusammengefaßt, die mit der gleichen Echozeit, d.h. im gleichen zeitlichen Abstand vom Hochfrequenzimpuls erfaßt wurden. Dabei wird eine erste Gruppe aus den MR-Echo-Signalen gebildet, die jeweils im Zeitraum A₁₁ einer jeden Sequenz entlang der Strahlenpfade P₁₁, P₂₁ ... usw. erfaßt wurden. Eine zweite Gruppe umfaßt die längs der Strahlenpfade P₁₂, P₂₂ usw. MR-Echosignale, und die n-te Gruppe umfaßt die MR-Signale, die längs des Pfades P₁ₙ und der korrespondierenden Pfade in den anderen Sequenzen erfaßt wurden. Jeder Gruppe kann man eine bestimmte Echozeit zuordnen; z.B. den jeweils zuerst (längs der Pfade P₁₁, P₂₁ usw. gemessenen MR-Echosignalen die Echozeit T_{E1} (die mit der Mitte des Leseintervalls A₁₁ zusammenfällt), den danach - im Intervall A₁₂ - erfaßten MR-Echosignalen die Echozeit T_{E2} usw. Aus den MR-Echosignalen jeder Gruppe kann jeweils ein (Teil-) MR-Bild mit niedriger Auflösung rekonstruiert werden. Diese (Teil-) MR-Bilder können dazu benutzt werden, um
a) ein hochaufgelöstes MR-Gesamtbild zu rekonstruieren und um
b) die Frequenzverteilung in der Schicht abzuleiten.

a) Die Teilbilder haben aufgrund unvermeidlicher Abweichungen zwischen der Larmorfrequenz der Kernmagnetisierung und der Frequenz, auf die der Oszillator 13 (Fig. 1) abgestimmt ist, eine Phasenabweichung, so daß sich Artefakte ergeben würden, wenn man die MR-Bilder aus den einzelnen Gruppen von MR-Echosignalen unmittelbar zu einem MR-Gesamtbild zusammenfügen würde. Diese Phasenabweichungen sind der für die betreffende Gruppe von MR-Signalen geltenden Echozeit proportional und sie lassen sich auf einfache Weise für jedes (Teil-) MR-bild aus dem räumlichen Mittelwert der Phase in den einzelnen Bildpunkten des betreffenden MR-Bildes ableiten. Indem man nun alle Bildpunkte des MR-Bildes mit einem entsprechenden Phasenfaktor multipliziert, lassen sich die erwähnten Phasenabweichungen kompensieren. Die auf diese Weise phasenkompensierten MR-Bilder (mit niedriger räumlicher Auflösung) können dann zu einem MR-Gesamtbild mit hoher räumlicher Auflösung kombiniert werden, ohne daß die geschilderten Bildartefakte auftreten.
b) Die (Teil-) MR-Bilder, die aus den einzelnen Gruppen von MR-Echosignalen rekonstruiert werden, unterscheiden sich lediglich durch die Echozeiten (T_{E1}) und T_{E2}) voneinander. Deshalb kann man aus zwei solcher MR-Bilder die Frequenzverteilung ableiten, wie in der EP-OS 465 139 beschrieben. Danach werden die komplexen MR-Bildwerte, die jeweils dem gleiche MR-Bildpunkt zugeordnet sind, durcheinander dividiert, woraus ein komplexes MR-Bild resultiert, dessen Phase in einem Bildpunkt der Phasendifferenz in dem betreffenden Bildpunkt der Bilder entspricht, aus denen es abgeleitet wird. Der zeitliche Abstand zwischen den MR-Echosignalen, aus denen die beiden MR-Bilder abgeleitet werden, muß dabei so gering sein, daß die maximal auftretende Phasendifferenz kleiner als ± π (180°) ist. Dies ist notwendig, um eine Mehrdeutigkeit auszuschließen und in der Regel auch realisierbar. Dividiert man die auf diese Weise für jeden Bildpunkt erhaltene Phase durch die Differenz T der Echozeiten (T = T_{E1} - T_{E2}), dann erhält man die Frequenzverteilung, die angibt, in welchem Maß die Frequenz in den einzelnen Bildpunkten aufgrund der Magnetfeldinhomogenitäten von einem Mittelwert abweicht.

Wegen des linearen Zusammenhanges zwischen der Larmorfrequenz und der Stärke des Magnetfeldes ist die Frequenzverteilung ein direktes Maß für die Inhomogenität des Magnetfeldes. Aus der Frequenzverteilung können daher die Shim-Felder berechnet werden, durch die die Inhomogenität des Magnetfeldes in der untersuchten Schicht reduziert werden kann. Wenn man sich auf die Shim-Felder erster Ordnung beschränkt und die dafür erforderlichen Ströme in der Gradientenspulenanordnung 2 erzeugt, kann die Shim-Spulenanordnung 30 entfallen. Diese während der Untersuchung konstanten Ströme werden von der Steuereinheit 5 bzw der Generatoranordnung 4 aus der Frequenzverteilung errechnet, den zeitlich veränderlichen Strömen für die Bildgebung überlagert und der GradientenVerstärkeranordnung vorgegeben. Wenn man auch Shim-Felder höherer Ordnung benötigt, sind die Shim-Spulen 30 erforderlich; die Größe der darin einzustellenden Ströme wird durch die Steuereinheit 5 berechnet.- Da die Frequenzverteilung auf die erfindungsgemäße Weise fortlaufend aktualisiert werden kann, ohne die eigentliche MR-Untersuchung zu unterbrechen, kann die Einstellung der Shim-Felder fortlaufend den sich ändernden Verhältnissen angepaßt werden.

## Patentansprüche

1. MR-Verfahren, bei dem aus wenigstens zwei mit unterschiedlichen Echozeiten akquirierten MR-Bildern eines einem stationären Magnetfeld ausgesetzten Untersuchungsbereiches eine die Magnetfeldinhomogenität im Untersuchungsbereich repräsentierende Frequenzverteilung abgeleitet wird, wobei in mehreren Sequenzen die Kernmagnetisierung im Untersuchungsbereich durch wenigstens je einen Hochfrequenzimpuls (RF) angeregt wird
**dadurch gekennzeichnet, daß**
a) nach jeder Anregung der Kernmagnetisierung wenigstens zwei MR-Echosignale längs unterschiedlichen Pfaden (P₁₁, P₁₂ ... P₁ₙ) im k-Raum akquiriert werden, die den Nullpunkt des k-Raums in unterschiedlichen Richtungen erreichen bzw. verlassen,
b) MR-Echosignale(P₁₁, P₂₁ ...), die in unterschiedlichen Sequenzen den Nullpunkt des k-Raums in unterschiedlichen Richtungen erreichen bzw. verlassen und die jeweils im gleichen zeitlichen Abstand von der Anregung der Kernmagnetisierung akquiriert wurden, in Gruppen zusammengefaßt werden,
c) aus den MR-Echosignalen wenigstens zweier Gruppen je ein MR-Bild rekonstruiert wird und
d) aus wenigstens zwei dieser MR-Bilder die Frequenzverteilung abgeleitet wird.

2. MR-Verfahren nach Anspruch 1,
**dadurch gekennzeichnet, daß** die aus den einzelnen Gruppen abgeleiteten MR-Bilder zu einem MR-Gesamtbild überlagert werden.

3. MR-Verfahren nach Anspruch 1 oder 2,
**dadurch gekennzeichnet, daß** zur lokalen Änderung des stationären Magnetfeldes Shim-Spulen (30) und/oder eine Gradientenspulenanordnung vorgesehen sind und daß die Ströme durch die Shim-Spulen und/oder die Gradientenspulenanordnung in Abhängigkeit von der ermittelten Frequenzverteilung gesteuert werden.

4. MR-Verfahren nach Anspruch 3, wobei die Lage des Untersuchungsbereiches fortlaufend verändert werden,
**dadurch gekennzeichnet, daß** die Sequenzen fortlaufend auf den
Untersuchungsbereich einwirken und daß die Ströme durch die Shim-Spulen (30) und/oder die Gradientenspulenanordnung fortlaufend in Abhängigkeit von der ermittelten Frequenzverteilung gesteuert werden.

5. MR-Verfahren nach Anspruch 1,
**dadurch gekennzeichnet**,
- daß während der Akquisition eines jeden MR-Echosignals ein konstanter Lesegradient (z.B. Gₓ₂, G_{y2}) erzeugt wird, so daß die MR-Echosignale im k-Raum längs einer durch dessen Nullpunkt verlaufenden Geraden erfaßt werden,
- daß die während der Akquisition der verschiedenen MR-Signale erzeugten Lesegradienten unterschiedliche Richtung haben, so daß sich die Geraden im Nullpunkt des k-Raumes schneiden,
- daß zwischen den innerhalb einer Sequenz geschalteten Lesegradienten Intervalle bestehen, in denen magnetische Gradientenfelder (Gₓ₃, Gₓ₅, Gₓ₇) mit solchem zeitlichen Verlauf eingeschaltet werden, daß sich im k-Raum eine Verschiebung von dem Endpunkt der Geraden (z.B. P₁₁), längs der das vorhergehende MR-Echosignal akquiriert wurde, zum Anfangspunkt der Geraden (P₁₂) ergibt, längs der das nachfolgende MR-Echosignal erfaßt wird.

6. MR-Anordnung zur Durchführung des Verfahrens nach Anspruch 1 mit
- einem Magneten (1) zur Erzeugung eines homogenen stationären Magnetfeldes,
- einer Gradientenspulenanordnung (2) zur Erzeugung eines magnetischen Gradientenfeldes (Gₓ, G_{y}, G_{z}), dessen Gradient nach Größe und/oder Richtung veränderbar ist,
- wenigstens einer Hochfrequenzspulenanordnung (10, 20) zur Erzeugung von Hochfrequenzimpulsen (RF) bzw. zum Empfangen von MR-Echosignalen,
- Mitteln (24) zum Erzeugen von MR-Bildern aus den MR-Echosignalen und zum Ableiten einer Frequenzverteilung aus zwei mit unterschiedlichen Echozeiten akquirierten MR-Bildern,
- einer programmierbaren Steuereinheit (24) zum Steuern der vorgenannten Mittel und der Spulenanordnungen, in der Weise, daß
in mehreren Sequenzen die Kernmagnetisierung im Untersuchungsbereich durch wenigstens je einen Hochfrequenzimpuls (RF) angeregt wird, **dadurch gekennzeichnet, daß** die Steuereinheit so programmiert ist, daß
a) nach jeder Anregung der Kernmagnetisierung wenigstens zwei MR-Echosignale längs unterschiedlichen Pfaden (P₁₁, P₁₂ ... Pₙ) im k-Raum akquiriert werden, die den Nullpunkt des k-Raums in unterschiedlichen Richtungen erreichen bzw. verlassen,
b) MR-Echosignale (P₁₁, P₂₁), die in unterschiedlichen Sequenzen den Nullpunkt des k-Raums in unterschiedlichen Richtungen erreichen bzw. verlassen und die jeweils im gleichen zeitlichen Abstand von der Anregung der Kernmagnetisierung akquiriert wurden, in Gruppen zusammengefaßt werden,
c) aus den MR-Echosignalen wenigstens zweier Gruppen je ein MR-Bild rekonstruiert wird und
d) aus wenigstens zwei dieser MR-Bilder die Frequenzverteilung abgeleitet wird.

7. MR-Anordnung nach Anspruch 6
**dadurch gekennzeichnet, daß** die Steuereinheit so programmiert ist,
- daß in mehreren Sequenzen die Kernmagnetisierung im Untersuchungsbereich durch wenigstens je einen Hochfrequenzimpuls angeregt wird und nach jeder Anregung der Kernmagnetisierung mehrere MR-Echosignale längs Pfaden im k-Raum akquiriert werden, die den Nullpunkt des k-Raums in unterschiedlichen Richtungen erreichen bzw. verlassen,
- daß während der Akquisition eines jeden MR-Echosignals ein konstanter Lesegradient (z.B. Gₓ₂, G_{y2}) erzeugt wird, so daß die MR-Echosignale im k-Raum längs einer durch dessen Nullpunkt verlaufenden Geraden erfaßt werden,
- daß die während der Akquisition der verschiedenen MR-Signale erzeugten Lesegradienten unterschiedliche Richtung haben, so daß sich die Geraden im Nullpunkt des k-Raumes schneiden,
- und daß zwischen den innerhalb einer Sequenz geschalteten Lesegradienten Intervalle bestehen, in denen magnetische Gradientenfelder (Gₓ₃, Gₓ₅, Gₓ₇) mit solchem zeitlichen Verlauf eingeschaltet werden, daß sich im k-Raum eine Verschiebung von dem Endpunkt der Geraden (z.B. P₁₁), längs der das vorhergehende MR-Echosignal akquiriert wurde, zum Anfangspunkt der Geraden (P₁₂) ergibt, längs der das nachfolgende MR-Echosignal erfaßt wird.

## Claims

1. An MR method in which a frequency map which represents the magnetic field inhomogeneity in an examination zone is derived from at least two MR images of the examination zone, exposed to a steady magnetic field, which MR images have been acquired with different echo times, the nuclear magnetization in the examination zone being excited by at least one respective RF pulse (RF) in a plurality of sequences, **characterized in that**
a) after each excitation of the nuclear magnetization at least two MR echo signals are acquired along different paths (P₁₁, P₁₂ ... P₁ₙ) in the k-space which reach or emanate from the zero point of the k-space in different directions,
b) MR echo signals (P₁₁, P₂₁ ...) which reach or emanate from the zero point of the k-space in different directions in different sequences and have been acquired at the same temporal distance from the excitation of the nuclear magnetization are combined so as to form groups,
c) a respective MR image is reconstructed from the MR echo signals of at least two groups, and
d) the frequency map is derived from at least two of these MR images.

2. An MR method as claimed in Claim 1, **characterized in that** the MR images derived from the individual groups are superposed so as to form an MR overall image.

3. An MR method as claimed in Claim 1 or 2, **characterized in that** for local variation of the steady magnetic field there are provided shim coils (30) and/or a gradient coil system, and that the currents through the shim coils and/or the gradient coil system are controlled in dependence on the frequency map determined.

4. An MR method as claimed in Claim 3, in which the position of the examination zone is continuously changed, **characterized in that** the sequences act continuously on the examination zone and that the currents through the shim coils (30) and/or the gradient coil system are controlled continuously in dependence on the frequency map determined.

5. An MR method as claimed in Claim 1, **characterized in that**
- during the acquisition of each MR echo signal a constant read gradient (for example, Gₓ₂, G_{y2}) is generated so that the MR echo signals are acquired in the k-space along a straight line passing through the zero point thereof,
- the read gradients generated during the acquisition of the various MR signals have a different direction so that the straight lines intersect at the zero point of the k-space,
- between the read gradients switched within a sequence there are intervals in which magnetic gradient fields (Gₓ₃, Gₓ₅, Gₓ₇) are applied whose variation in time is such that in the k-space a shift occurs from the end point of the straight line (for example, P₁₁) along which the preceding MR echo signal has been acquired to the starting point of the straight line (P₁₂) along which the next MR echo signal is acquired.

6. An MR device for carrying out the method claimed in Claim 1, including
- a magnet (1) for generating a homogeneous, steady magnetic field,
- a gradient coil system (2) for generating a magnetic gradient field (Gₓ, G_{y}, G_{z}) whose gradient can be varied in respect of magnitude and/or direction,
- at least one RF coil system (10, 20) for generating RF pulses (RF) and for receiving MR echo signals,
- means (24) for generating MR images from the MR echo signals and for deriving a frequency map from two MR images acquired with different echo times,
- a programmable control unit (24) for controlling said means and the coil systems, in such a manner that the nuclear magnetization in the examination zone is excited by at least one respective RF pulse (RF) in a plurality of sequences, **characterized in that** the control unit is programmed so that
a) after each excitation of the nuclear magnetization at least two MR echo signals are acquired along different paths (P₁₁, P₁₂ ... Pₙ) in the k-space which reach or emanate from the zero point of the k-space in different directions,
b) MR echo signals (P₁₁, P₂₁) which reach or emanate from the zero point of the k-space in different directions in different sequences and have been acquired at the same temporal distance from the excitation of the nuclear magnetization are combined so as to form groups,
c) a respective MR image is reconstructed from the MR echo signals of at least two groups, and
d) the frequency map is derived from at least two of these MR images.

7. An MR device as claimed in Claim 6, **characterized in that** the control unit is programmed so that
- in a plurality of sequences the nuclear magnetization in the examination zone is excited by at least one respective RF pulse and after each excitation of the nuclear magnetization a plurality of MR echo signals are acquired along paths in the k-space which reach or emanate from the zero point of the k-space in different directions,
- during the acquisition of each MR echo signal a constant read gradient (for example, Gₓ₂, G_{y2}) is generated so that the MR echo signals are acquired in the k-space along a straight line extending through the zero point thereof,
- the read gradients generated during the acquisition of the various MR signals have a different direction so that the straight lines intersect at the zero point of the k-space,
- between the read gradients switched within a sequence there are intervals in which magnetic gradient fields (Gₓ₃, Gₓ₅, Gₓ₇) are applied whose variation in time is such that in the k-space a shift occurs from the end point of the straight line (for example, P₁₁) along which the preceding MR echo signal has been acquired to the starting point of the straight line (P₁₂) along which the next MR echo signal is acquired.

## Revendications

1. Procédé RM, une distribution de fréquence représentant l'inhomogénéité du champ magnétique dans la zone d'examen étant dérivée d'au moins deux images RM acquises avec des temps d'écho différents d'une zone d'examen exposée à un champ magnétique stationnaire, la magnétisation nucléaire dans la zone d'examen étant excitée par respectivement une impulsion à haute fréquence (RF) au moins dans plusieurs séquences,
**caractérisé en ce**
a) qu'après chaque excitation de la magnétisation nucléaire, au moins deux signaux d'écho RM sont acquis le long de différentes voies (P₁₁, P₁₂, ..., P₁ₙ) dans l'espace k qui atteignent ou quittent le point zéro de l'espace k dans les différentes directions;
b) que des signaux d'écho (P₁₁, P₂₁, ...) qui atteignent ou quittent dans différentes séquences le point zéro de l'espace k dans différentes directions et qui ont respectivement été acquis dans le même intervalle temporel par l'excitation de la magnétisation nucléaire, sont rassemblés en groupes;
c) qu'une image RM est respectivement reconstruite à partir des signaux d'écho RM d'au moins deux groupes et
d) que la distribution de fréquence est dérivée d'au moins deux de ces images RM.

2. Procédé RM selon la revendication 1,
**caractérisé en ce que** les images RM dérivées des différents groupes sont superposées en une image globale RM.

3. Procédé RM selon l'une des revendications 1 ou 2,
**caractérisé en ce qu'**en vue de la variation locale du champ magnétique stationnaire, des bobines de compensation (30) et/ou un agencement de bobines à gradient sont prévus et que les courants sont commandés par les bobines de compensation et/ou l'agencement de bobines à gradient en fonction de la distribution de fréquence déterminée.

4. Procédé RM selon la revendication 3, la position de la zone d'examen variant en permanence,
**caractérisé en ce que** les séquences agissent en permanence sur la zone d'examen et que les courants sont en permanence commandés par les bobines de compensation (30) et/ou l'agencement de bobines à gradient en fonction de la distribution de fréquence déterminée.

5. Procédé RM selon la revendication 1,
**caractérisé en ce**
- que, pendant l'acquisition de chaque signal d'écho RM, un gradient de lecture constant (par exemple Gₓ₂, G_{y2}) est produit de telle sorte que les signaux d'écho RM sont enregistrés dans l'espace k le long d'une droite passant par son point zéro;
- que les gradients de lecture produits pendant l'acquisition des différents signaux RM ont des directions différentes si bien que les droites se coupent dans le point zéro de l'espace k;
- qu'il existe entre les gradients de lecture montés à l'intérieur d'une séquence des intervalles dans lesquels les champs de gradient magnétiques (Gₓ₃, Gₓ₅, Gₓ₇) sont activés avec un déroulement temporel tel qu'un déphasage du point final de la droite (par exemple, P₁₁) le long de laquelle le signal d'écho RM précédent a été acquis est obtenu dans l'espace k vers le point initial de la droite (P₁₂) le long de laquelle le signal d'écho RM suivant est enregistré.

6. Dispositif RM en vue de la mise en oeuvre du procédé selon la revendication 1 avec
- un aimant (1) en vue de la production d'un champ magnétique stationnaire homogène;
- un agencement de bobines à gradient (2) en vue de la production d'un champ à gradient magnétique (Gₓ, G_{y}, G_{z}) dont le gradient varie en fonction de sa taille et/ou de sa direction;
- au moins un agencement de bobines à haute fréquence (10, 20) en vue de la production d'impulsions à haute fréquence (RF) ou en vue de la réception de signaux d'écho RM;
- des moyens (24) en vue de la production d'images RM à partir des signaux d'écho RM et en vue de la dérivation d'une distribution de fréquence à partir de deux images RM acquises avec des temps d'écho différents,
- une unité de commande programmable (24) en vue de commander des moyens précités et des agencements de bobines de telle manière que la magnétisation nucléaire soit excitée dans la zone d'examen par au moins une impulsion à haute fréquence (RF) en plusieurs séquences, **caractérisé en ce que** l'unité de commande est programmée de telle sorte que
a) après chaque excitation de la magnétisation nucléaire, au moins deux signaux d'écho RM sont acquis dans l'espace k le long de différentes voies (P₁₁, P₁₂, ..., Pₙ) qui atteignent ou quittent le point zéro de l'espace k dans différentes directions;
b) des signaux d'écho RM (P₁₁, P₂₁) qui atteignent ou quittent le point zéro de l'espace k dans différentes directions dans différentes séquences et qui ont respectivement été acquis dans le même intervalle temporel par l'excitation de la magnétisation nucléaire et sont rassemblés en groupes;
c) une image RM est respectivement reconstruite à partir des signaux d'écho RM d'au moins deux groupes et
d) la distribution de fréquence est dérivée d'au moins deux de ces images RM.

7. Dispositif RM selon la revendication 6,
**caractérisé en ce que** l'unité de commande est programmée de telle sorte
- que, dans plusieurs séquences, la magnétisation nucléaire dans la zone d'examen est excitée par au moins une impulsion à haute fréquence et, après chaque excitation de la magnétisation nucléaire, plusieurs signaux d'écho RM sont acquis le long de voies dans l'espace k qui atteignent ou quittent le point zéro de l'espace k dans différentes directions,
- que, pendant l'acquisition de chaque signal d'écho RM, un gradient de lecture constant (par exemple Gₓ₂, G_{y2}) est produit de telle sorte que les signaux d'écho RM sont enregistrés dans l'espace k le long d'une droite passant par son point zéro,
- que les gradients de lecture produits pendant l'acquisition de différents signaux RM ont différentes directions de telle sorte que les droites se coupent dans le point zéro de l'espace k et
- qu'entre les gradients de lecture montés dans une séquence, il existe des intervalles dans lesquels les champs à gradient magnétiques (Gₓ₃, Gₓ₅, Gₓ₇) sont excités avec un intervalle temporel tel qu'il en résulte dans l'espace k un décalage du point final des droites (par exemple P₁₁), le long desquelles le signal d'écho RM précédent a été acquis vers le point de départ des droites (P₁₂) le long desquelles le signal d'écho RM suivant est enregistré.
